# EUROPÄISCHE PATENTSCHRIFT

(11) **EP 2 210 155 B1**
(45) Veröffentlichungstag und Bekanntmachung des Hinweises auf die Patenterteilung: **31.08.2011**
(21) Anmeldenummer: 08849733.4
(22) Anmeldetag: 12.11.2008
(51) Int. Cl.: G05B 19/404, A61G 7/018

(54) **ELEKTROMOTORISCHE ANTRIEBSANORDNUNG**
ELECTRIC-MOTOR DRIVE ARRANGEMENT
DISPOSITIF D'ENTRAÎNEMENT PAR MOTEUR ÉLECTRIQUE

(30) Priorität: 13.11.2007 DE 102007054421
(43) Veröffentlichungstag der Anmeldung: 28.07.2010
(73) Patentinhaber: Dewert Antriebs- und Systemtechnik GmbH, 32278 Kirchlengern (DE)
(72) Erfinder: GEHRKE, Karsten, 32457 Porta Westfalica (DE); LANGEJÜRGEN, Stefan, 32602 Vlotho (DE); LOLEY, Steffen, 49074 Osnabrück (DE)
(74) Vertreter: Dantz, Jan Henning
(86) Internationale Anmeldenummer: PCT/EP2008/065427
(87) Internationale Veröffentlichungsnummer: WO 2009/062983

(56) Entgegenhaltungen:
- EP-A- 1 524 759
- WO-A-2007/085388
- DE-A1- 3 635 442
- JP-A- 9 243 273
- US-A- 5 767 645

## Beschreibung

Die Erfindung betrifft eine elektromotorische Antriebsanordnung gemäß dem Oberbegriff des Anspruches 1 und ein Verfahren zum Feststellen eines Verschleißzustands dieser Antriebsanordnung gemäß dem Oberbegriff des Anspruches 12.

Die elektromotorische Antriebsanordnung kann ein linear verfahrbares oder ein rotierend bewegliches Abtriebselement aufweisen, welches mit einem zu verstellenden Bauteil eines Möbels, beispielsweise in Form eines Lattenrostes oder eines Sessels, oder welches mit einem zu verstellenden Bauteil eines Pflegeartikels, beispielsweise in Form eines Krankenhausbettes, eines Pflegebettes, eines Patientenlifters oder einer Liege in Wirkverbindung steht. Die Bedienung der erfindungsgemäßen elektromotorischen Antriebsanordnung kann durch Betätigung eines Fußschalters und/oder eines Handschalters erfolgen, welcher direkt oder über eine zwischengeschaltete Steuereinheit den mindestens einen Elektromotor steuert.

Derartige elektromotorische Antriebsanordnungen sind bekannt und haben sich in der Praxis bestens bewährt. Sie sind in sich gekapselt und wartungsfrei ausgeführt. Sie unterliegen jedoch durch ihre Benutzung einem Verschleiß und einer Alterung und ihre Lebensdauer ist begrenzt. Dabei hängt der Verschleiß von den Einsatzbedingungen ab, wie zum Beispiel durch die Häufigkeit der Benutzung, die Einschaltdauer, im Belastungsgrad und in der Art der Belastung gegeben ist.

Bei einigen Anwendungen einer elektromotorischen Antriebsanordnung ist ein Überblick über die Lebensleistung dessen erforderlich. Dies ist zum Beispiel im Medizinbereich der Fall, wobei bestimmte Wartungs- bzw. Austauscharbeitcn nach bestimmter Betriebszeit gemäß einschlägiger Vorschriften notwendig werden können. In der Praxis haben sich jedoch manuelle Aufzeichnungen nicht bewährt, da sie aufwendig sind, und die effektive Lebensleistung nur geschätzt werden kann. Ebenfalls kann die Lebensleistung an hand der lahreszahl des Typenschildes nur geschätzt werden, so dass eine elektromotorische Antriebsanordnung zu früh als verbraucht eingestuft oder zu spät gewartet werden kann.

Aus der EP 1 524 759 A2 ist eine Kontrolleinrichtung für ein mit elektrischen Antrieben ausgerüstetes Bett bekannt. Bei diesem Bett werden nicht nur die Rückenlehne und das Fußteil elektromotorisch verstellt, sondern der Bettrahmen wird auch in der Höhe verstellt. Die Kontrolleinrichtung ist mit einer Gedächtniseinrichtung versehen, welche den Start einer Verstellung anzeigt und auch das Ende. Auch der Verstellvorgang für den höhenverstellbaren Rahmen wird angezeigt. Darüber hinaus kann auch die Verstelldauer für jedes zu verstellende Bauteil angezeigt werden. Darüber hinaus ist die Einrichtung noch mit einem Kontrollschalter ausgerüstet. Ferner ist die Einrichtung noch mit einer Ausgabeeinrichtung ausgestattet, welche die ermittelten Werte an eine externe Auswerteeinrichtung übermittelt.

Aus der DE 36 35 442 A1 ist ein Verfahren und eine Vorrichtung zum Korrigieren eines Totgangs als Hauptursache eines Fehlers bekannt. Dieser Fehler tritt zwischen einer ermittelten Stellung einer Antriebseinrichtung oder eines angetriebenen Elements und einer Stellung zwischen einem anderen Teil auf. Die Steuerung dieser Stellung des durch die Antriebseinheit bewegten angetriebenen Elementes wird gesteuert. Die Totganggröße und eine Bezugsbewegungseinrichtung werden gespeichert und bei der Bewegung in Abhängigkeit von einem Bewegungsbefehl unmittelbar nach dem Inbetriebsetzen einer Antriebseinrichtung wird das angetriebene Element in eine Sollstellung bewegt, sofern die Bewegungseinrichtung mit der Bezugsbewegungsrichtung übereinstimmt. Die Antriebseinrichtung und die Totganggröße können zusätzlich zur befohlenen Bewegung bewegt werden, wenn die befohlene Bewegungseinrichtung umgekehrt zur Bewegungsrichtung verläuft.

Der Erfindung liegt somit die Aufgabe zugrunde, eine elektromotorische Antriebsanordnung zu schaffen, welche die oben genannten Nachteile nicht mehr aufweist, zudem einfach montiert werden kann und eine Einrichtung aufweist, welche zumindest die Lebensleistung, d.h. den Verschleißzustand der elektromotorischen Antriebsanordnung erfasst und dem Benutzer anzeigen kann.

Die Aufgabe der Erfindung wird durch eine elektromotorische Antriebsanordnung mit den kennzeichnenden Merkmalen des Anspruch 1 und durch ein Verfahren mit den kennzeichnenden Merkmalen des Anspruchs 12 gelöst, insbesondere indem die elektromotorische Antriebsanordnung zumindest eine Aufzeichnungseinrichtung in Form einer Messdatenverarbeitungsvorrichtung mit einem daran angesetzten oder darin integrierten Speicherbaustein mit einem nicht flüchtigen Speicher, sowie eine Zähleinrichtung nach Art eines Addierers und einen Vergleicher aufweist, wobei der Speicherbaustein einen der Lebensleistung bzw. dem Verschleißzustand der elektromotorischen Antriebsanordnung entsprechenden abgespeicherten Wert aufweist. Die Messdatenverarbeitungsvorrichtung ist zur Ermittlung dieses zumindest einen zu dem Verschleiß der elektromotorischen Antriebsanordnung korrespondierenden Wertes vorgesehen, welcher in dem Speicher abgelegt und angezeigt wird.

Gemäß einer denkbar einfachen Ausführungsform ist der jeweilige Steuerschalter für den jeweiligen Elektromotor mit einer Messdatenverarbeitungsvorrichtung gekoppelt. Dabei ist die Messdatenverarbeitungsvorrichtung mit dem Ausgang einer Einschaltzähleinrichtung verbunden, wobei die Messdatenverarbeitungsvorrichtung die Anzahl der Einschaltvorgänge zählt und sie zu dem zuvor in dem nicht flüchtigen Speicherbaustein befindenden Wert hinzu addiert. Der jeweilige Steuerschalter des jeweiligen Elektromotors kann dabei durch einen Schalter in einer Bedienungseinrichtung gebildet sein. In einer anderen Ausführungsform kann der Steuerschalter durch einen elektromechanischen Schalter der Steuereinheit gebildet sein. Der Steuerschalter kann jedoch auch durch einen Schalter gebildet ein, dessen Schaltausgang durch einen Stromfluss des Motorstromkreises auslösbar ist.

Ein baulich einfache und kompakte Bauweise ergibt sich dadurch, dass der Speicherbaustein an der Messdatenverarbeitungsvorrichtung angeordnet oder in ihr integriert ist und zur Speicherung des zumindest einen zu dem Verschleiß der elektromotorischen Antriebsanordnung korrespondierenden Wertes vorgesehen ist, dass die Messdatenverarbeitungsvorrichtung weiterhin noch eine Recheneinheit zur Ausführung eines Rechenalgorithmus aufweist, wobei der Rechenalgorithmus zur Berechnung des zu dem Verschleiß der elektromotorischen Antriebsanordnung korrespondierenden Wertes aus Betriebsparametern der elektromotorischen Antriebsanordnung als Eingangsgrößen angepasst ist.

In Weiterführung dieser Ausführungsform werden nur Einschaltvorgänge in nur einer Drehrichtung des Elektromotors gezählt

Gemäß einer weiteren Ausführungsfonn weist die Messdatenverarbeitungsvorrichtung ein Rechenprogramm und einen Zeittaktgeber oder eine Zeitmesseinrichtung auf. Dabei wird in einer vorbestimmten Rechenroutine eine Verknüpfung zwischen der Anzahl der Einschaltvorgänge und der Einschaltdauer des jeweiligen Elektromotors geschlossen, so dass das Rechenergebnis in Form eines Wertes zu dem zuvor gespeicherten Wert des nicht flüchtigen Speichers hinzu addiert wird.

Gemäß einer anderen Ausführungsform wird zumindest eine elektrische Größe beispielsweise in Form des elektrischen Stromes gemessen. Dazu weist der Stromkreis des jeweiligen Elektromotors eine Strommesseinrichtung auf, welche einen elektrischen Widerstand beispielsweise in Form eines Shunts aufweisen kann. Es hat sich gezeigt, dass der Charakter des Stromflusses ein Maß für die mechanische Leistungsabgabe der elektromotorischen Antriebsanordnung bildet und ein Abbild für den mechanischen Verschleiß und für den elektrischen Verschleiß darstellt. Weist der Motorstromkreis beispielsweise einen hohen Stromfluss auf, so ist die mechanische Leistungsabgabe der elektromotorischen Antriebsanordnung ebenfalls hoch ausgebildet. Weist die Messdatenverarbeitungsvorrichtung gemäß einer anderen Ausführungsform zudem noch eine Zeitmesseinrichtung auf und weist der Motorstromkreis entlang einer langen Einschaltdauer einen hohen Stromfluss auf, so weist die elektromotorische Antriebsanordnung ein hohes Maß an abgegebener mechanischer Arbeit auf.

Gemäß einer weiteren Ausführungsform weist die Messdatenverarbeitungsvorrichtung ein anderes Rechenprogramm auf, welches mit dem Ausgang einer Strommesseinrichtung und mit einer Zeitmesseinrichtung in Wirkverbindung steht. Dazu kann ein Mikrocontroller vorgesehen sein, dessen mindestens einer Eingang mit einem elektrischen Widerstand beispielsweise in Form eines Shunts verbunden ist, welcher in dem Motorstromkreis eingesetzt ist. Dabei wird in einer vorbestimmten Rechenroutine der Ausgang der Strommesseinrichtung mit der Zeitmesseinrichtung verknüpft, so dass das Rechenergebnis in Form eines Wertes zu dem zuvor gespeicherten Wert des nicht flüchtigen Speichers hinzu addiert wird.

In Weiterführung der vorgenannten Ausführungsfonnen weist die Messdatenverarbeitungsvorrichtung ein anderes Rechenprogramm auf, welches mit dem Ausgang einer Strommesseinrichtung, einer Zeitmesseinrichtung und mit dem Ausgang einer Einschaltzähleinrichtung verbunden ist. Dabei wird nach einer vorbestimmten Rechenroutine ein Rechenwert bestimmt, der zu dem zuvor gespeicherten Wert des nicht flüchtigen Speichers hinzu addiert wird.

Es hat sich gezeigt, dass die Einschaltdauer, die Einschalthäufigkeit und die Höhe des Stromflusses des jeweiligen Elektromotors ein wesentliches Abbild der Lebensleistung der elektromotorischen Antriebsanordnung darstellen. Es hat sich weiterhin gezeigt, dass beispielsweise eine hohe Einschaltdauer bei einem geringen Stromfluss sich nur in geringem Maße auf die Lebensleistung auswirkt. Im Gegensatz dazu hat sich gezeigt, dass ein hoher Stromfluss, insbesondere ein überhöhter Stromfluss als Reaktion auf eine mechanische Überbelastung der elektromotorischen Antriebsanordnung einen sehr hohen Einfluss auf dessen Lebensleistung ausübt. Ein anderer hoher Einfluss auf die Lebensleistung der elektromotorischen Antriebsanordnung kann durch eine hohe Einschalthäufigkeit gegeben sein, wobei der Elektromotor für nur kurze Pausen ausgeschaltet ist.

Die Messdatenverarbeitungsvorrichtung sieht deswegen eine Rechenroutine vor, welche diese Eigenschaften berücksichtigt und dementsprechend einen hohen Rechenwert bei einem hohen Einfluss auf die Lebensleistung oder einen geringeren Rechenwert bei einem kleinen Einfluss auf die Lebensleistung ausgibt, der zu dem zuvor in dem nicht flüchtigen Speicher abgespeicherten Wert hinzu addiert wird. Die Rechenroutine kann fest in der Messdatenverarbeitungsvorrichtung eingesetzt sein oder gemäß einer hartverdrahteten Ausführung durch ihn gebildet sein. Gemäß einer weiteren Ausführungsform kann die Rechenroutine austauschbar ausgebildet sein. Dazu weist die Messdatenverarbeitungsvorrichtung Anschlüsse auf, welche über eine drahtgebundene oder drahtungebundene Übertragungsstrecke mit einem Programmiergerät in Verbindung stehen.

Bei den zuvor genannten Ausführungsformen kann die Messdatenverarbeitungsvorrichtung einen Mikrocontroller und einen nicht flüchtigen Speicher aufweisen. Er kann mit ihnen auch verknüpft sein oder durch sie gebildet sein. Dabei ist gemäß einer bevorzugten Ausführungsform die Messdatenverarbeitungsvorrichtung als Digitalrechner ausgebildet, während der nicht flüchtige Speicherbaustein den gespeicherten Wert in digitaler Form speichert. Gemäß einer anderen Ausführungsform einer Messdatenverarbeitungsvorrichtung ist dieser nach Art eines analogen Rechners beispielsweise in Form miteinander verschalteter Operationsverstärker ausgeführt, während der nicht flüchtige Speicher zumindest einen Integrierer aufweist.

Der Speicherbaustein ist ferner mit einem Vergleicher verbunden, der Bestandteil einer Messdatenverarbeitungsvorrichtung sein kann. Der Vergleicher vergleicht den im Speicherbaustein gespeicherten Ist-Wert mit dem ihm vorgegebenen Soll-Werten und gibt an seinem Ausgang ein Schaltsignal aus, sobald der Ist-Wert den Soll-Wert erreicht oder überschreitet. Gemäß einer weiteren Ausführungsform sind dem Vergleicher mehrere Soll-Werte zugeordnet. Dabei kann der Vergleicher mehrere Schaltausgänge und/oder Schaltsignale an seinem Ausgang aufweisen.

In vorteilhafter Ausgestaltung sieht die elektromotorische Antriebsanordnung eine Anzeigeeinrichtung vor, welche mit dem Vergleicher und/oder mit der Messdatenverarbeitungsvorrichtung verschaltet ist. In vorteilhafter Ausgestaltung ist sie als optische Anzeigeeinrichtung ausgebildet und kann beispielsweise durch eine LCD- oder durch eine LED-Anzeige gebildet sein. Sie kann mehrere Anzeigeblöcke aufweisen, wobei jeder Anzeigeblock mit einem Schaltausgang des Vergleichers und/oder der Messdatenverarbeitungsvorrichtung verschaltet ist. Die Anzeigeblöcke können ein- oder mehrfarbig ausgebildet sein.

Dabei ist jedem Anzeigeblock ein vorbestimmter Soll-Wert zugeordnet. Dem Benutzer der elektromotorischen Antriebsanordnung kann gemäß dieser Ausführungsform optisch angezeigt werden, welche Lebensleistung die elektromotorische Antriebseinrichtung erreicht hat. Bei erreichen einer nahezu vollständigen Lebensleistung kann zudem noch die optische Anzeigeeinrichtung variieren beispielsweise blinkend ausgebildet sein, bei Erreichen oder Überschreiten der maximal zulässigen Lebensleistung kann ein Schaltausgang der Messdatenverarbeitungsvorrichtung ein Schaltsignal zu der Steuereinheit derart senden, dass der jeweilige Elektromotor abgeschaltet wird oder nur für kurze Einschaltdauern einschaltbar ist. In Weiterführung dieser Ausführung kann die Steuereinheit noch eine Drosseleinrichtung aufweisen, welche den jeweiligen Elektromotor beim Einschalten eine nur geringe elektrische Energie zuführt.

Gemäß einer weiteren Ausführungsform ist noch vorgesehen, dass der in dem nicht flüchtigen Speicher abgespeicherte Wert durch ein Auslesegerät beispielsweise in Form eines Laptop oder eines PC ausgelesen werden kann. Dazu kann der Wert über eine drahtgebundene oder über eine drahtlose Übertragungsstrecke dem Auslesegerät übermittelt werden.

Ferner kann der Speicherbaustein eine hohe Kapazität aufweisen, so dass in ihm über die Lebensdauer der elektromotorischen Antriebsanordnung zumindest ein Teil des Stromverlaufes und/oder der Einschaltdauer abspeicherbar ist. Gemäß einer weiteren Ausführungsform weist der Speicherbaustein mehrere abgespeicherte Werte in Form des maximalen Stromflusses und/oder dessen Häufigkeit auf.

Gemäß einer Ausführungsform der Rechenroutine weist die Rechenroutine einen Faktor in Form eines Arbeitsdauerfaktors auf, welcher variabel, jedoch in vorgegebenen Grenzen veränderbar ist. Dabei berücksichtigt der Arbeitsdauerfaktor die bereits getätigte Arbeit der elektromotorischen Antriebsanordnung und kann beispielsweise einen Wert zwischen 1 und 1,5 annehmen. Ist die elektromotorische Antriebsanordnung beispielsweise relativ neuwertig, so weist der Antriebsdauerfaktor einen geringen Wert auf, so dass der Arbeitsdauerfaktor einen Wert von 1 betragen kann. Gemäß einer Tabelle oder einer Rechenformel erhöht sich der Arbeitsdauerfaktor in Schritten oder kontinuierlich mit zunehmender Nutzung der elektromotorischen Antriebsanordnung und kann einen Maximalwert von 1,5 aufweisen. Die Tabelle oder die Rechenformel sind in einem nicht flüchtigen Speicher abgelegt. In vorteilhafter Weise wird somit eine oftmals benutzte elektromotorische Antriebsanordnung stärker von der Rechenroutine berücksichtigt als eine neuwertige Antriebsanordnung.

In Weiterführung dieser Ausführungsform ist die Höhe des Arbeitsdauerfaktors mit der Einschaltzähleinrichtung derart gekoppelt, dass sich der Arbeitsdauerfaktor mit zunehmender Anzahl der Einschaltvorgänge erhöht.

Eine andere Ausführungsform sieht eine Kopplung des Arbeitsdauerfaktors mit der Strommesseinrichtung vor, wobei die Strommesseinrichtung in Form eines Stromzählers den bereits verbrauchten Strom erfasst und wobei sich der Arbeitsdauerfaktor mit zunehmenden Stromzählerstand erhöht.

In Weiterführung der vorgenannten Ausführungsformen weist die Messdatenverarbeitungsvorrichtung ein weiteres Rechenprogramm auf, welches mit dem Ausgang einer Strommesseinrichtung und mit dem Ausgang einer Einschaltzähleinrichtung verbunden ist und wobei das Rechenprogramm einen vorher festlegbaren Arbeitsdauerfaktor auf weist. Dabei wird nach einer vorbestimmten Rechenroutine ein Rechenwert bestimmt, der zu dem zuvor gespeicherten Wert des nicht flüchtigen Speichers hinzu addiert wird.

Eine weitere Ausführungsform sieht eine Kombination der vorgenannten Ausführungsformen vor, wobei mindestens ein Arbeitsdauerfaktor sowohl mit der Einschaltzähleinrichtung als auch mit der Strommesseinrichtung gekoppelt ist.

Eine weitere Ausführungsform der elektromotorischen Antriebsanordnung sieht mindestens zwei nicht flüchtige Speicher mit jeweils zumindest einem Speicherabschnitt mit jeweils zumindest einem vorher festgelegten, gespeicherten Wert vor, wobei beispielsweise der erste nicht flüchtiger Speicher auf einen weiteren, vorher festlegbaren Wert rückstellbar ausgebildet ist. Eine Rückstellung kann beispielsweise manuell erfolgen und zweckdienlich sein, während der zweite, nicht flüchtige Speicher nur durch das Hinzuaddieren durch die Rechenroutine veränderbar ist. Dabei kann der zweite nicht flüchtige Speicher in einem oder mehreren weiteren Speicherabschnitten weitere gespeicherte Werte aufweisen, welche beispielsweise in Form von Messwertdaten im Laufe der Lebensdauer der Antriebsanordnung gesammelt wurden. Derartige Werte können Daten sein, welche beispielsweise für die Häufigkeit und/oder Höhe von Überbelastungen der elektromotorischen Antriebsanordnung repräsentativ sein können.

Wie eingangs näher beschrieben können die in den nicht flüchtigen Speichern abgespeicherten Werte durch ein Auslesegerät, beispielsweise in Form eines Laptop oder eines PC, ausgelesen werden. In vorteilhafter Weiterbildung dieser Ausführungsform kann das Auslesegerät in Form eines Adapters ausgebildet sein, welcher über eine eigene oder keine eigene Stromversorgung verfügt. Gemäß der Ausführungsform, dass der Adapter über keine eigene Stromversorgung verfügt, übernimmt dies die elektromotorische Antriebsanordnung, während der Adapter mit der elektromotorischen Antriebsanordnung elektrisch verbunden ist. In diesem Zusammenhang erfolgt gleichermaßen das Übertragen der im nicht flüchtigen Speicher befindenden Daten auf einen weiteren, jedoch im Adapter angeordneten nicht flüchtigen Speicher.

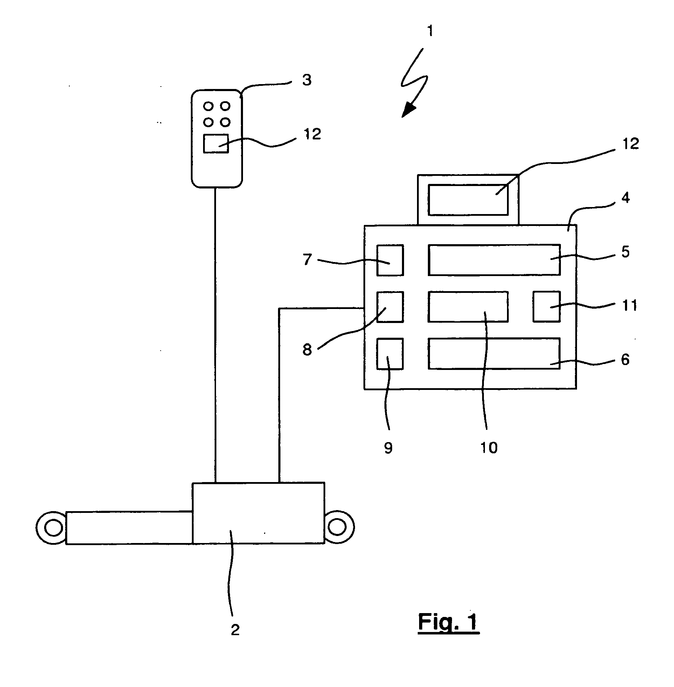

Die Erfindung wird nun mit Bezug auf die Figur der begleitenden Zeichnung anhand einer bevorzugten Ausführungsform beispielhaft erläutert.

Die Figur zeigt eine elektromotorische Antriebsanordnung 1 mit einem Motor 2, einer Bedienungseinrichtung 3 und einer Messdatenverarbeitungsvorrichtung 4.

Der Motor 2 ist mit einer nicht gezeigten Steuereinrichtung und einer zugehörigen Stromversorgung ausgestattet. Die Bedienungseinrichtung 3 ist an den Motor 2 bzw. an seine Steuereinrichtung angeschlossen und weist in diesem Beispiel Bedienungselemente zum Verfahren des Motors 2 und eine Anzeigeeinrichtung 12 auf.

Mit dem Motor 2 ist die Messdatenverarbeitungsvorrichtung 4 gekoppelt, welche hier aus Darstellungsgründen vergrößert gezeigt ist. Die Messdatenverarbeitungsvorrichtung 4 weist hier Folgendes auf: einen nicht flüchtigen Speicherbaustein 5; eine Recheneinheit 6; einen Zähler 7; eine Zeitmesseinrichtung 8; eine Strommesseinrichtung 9; einen Mikrocontroller 10; einen Vergleicher 11 und eine Anzeigeeinrichtung 12.

Die Kopplung der Messdatenverarbeitungsvorrichtung 4 mit dem Motor 2 ist dergestalt ausgeführt, dass Betriebsparameter desselben der Messdatenverarbeitungsvorrichtung 4 zugeleitet werden, in diesem Fall über elektrische Verbindungsleitungen.

Jede Betätigung der Bedienungseinrichtung 3 geht mit einem Einschaltvorgang des Motors 2 einher. Diese Einschaltvorgänge werden mittels des Zählers 7 gezählt und aufsummiert. Gleichzeitig erfolgt mittels der Zeitmesseinrichtung 8 eine Messung der Zeitdauer jedes Einschaltvorgangs des Motors 2. Während des Motorlaufs wird der Strom des Motors 2 durch die Strommesseinrichtung 9 gemessen.

Diese so erfassten und bearbeiteten drei Betriebsparameter Einschaltzahl, Einschaltdauer und Stromwert werden als Eingangsgrößen für einen Rechenalgorithmus verwendet, der durch den Mikrocontroller zum Beispiel als Programm ausgeführt wird. Aus diesen aktuellen Werten wird jeweils ein aktueller Wert mit dem Rechenalgorithmus berechnet und über den Vergleicher 11 mit einem gespeicherten, vorher festlegbaren Sollwert verglichen. Anhand dieses Vergleichs wird ein Verschleißzustand ermittelt, der als ein Wert in dem Speicherbaustein 5 abgelegt wird. Dieser Verschleißzustandswert ist auf der Anzeigeeinrichtung 12 für den Benutzer sichtbar in einer bestimmten Form, zum Beispiel als Grafik, numerischer Wert und/oder farbiges Symbol dargestellt. Dieser Wert ist auch aus dem Speicherbaustein 5, zum Beispiel mittels eines Wartungsgerätes, auslesbar.

In dem Speicherbaustein 5 können auch weitere Werte, zum Beispiel der oder die Soll-werte in Tabellenform, gespeichert sein. Auch eine Aufzeichnung der Betriebsparameter über der Zeit, zumindest teilweise, ist möglich.

Die Erfindung ist nicht auf das beschriebene Beispiel beschränkt.

So ist es auch denkbar, dass nur ein Betriebsparameter oder auch mehr als die drei angegebenen verwendet werden können.

Der Speicherbaustein 5 kann auch Erfahrungswerte in Tabellenform zur Angabe einer verbleibenden Betriebszeit bis zur nächsten Wartung aufweisen.

In einer einfachen Ausführungsform kann auch nur ein Betriebsparameter, zum Beispiel die Einschalthäufigkeit, aufsummiert werden und als ein Wert für den Verschleißzustand benutzt werden.

Ein anderes Ausführungsbeispiel sieht vor, dass anhand eines Betriebsparameters oder mehrerer ein Tabellenwert ermittelt wird, der dem Verschleißzustand entspricht. Dabei sind die zugehörigen Tabellenwerte zum Beispiel in dem Speicherbaustein 5 gespeichert.

## Patentansprüche

1. Elektromotorische Antriebsanordnung (1) mit mindestens einem Elektromotor (2) und mit mindestens einer Bedienungseinrichtung (3) und einem Speicherbaustein (5), wobei die elektromotorische Antriebsanordnung (1) ein linear verfahrbares oder ein rotierend bewegliches Abtriebselement aufweist, welches mit einem zu verstellenden Bauteil eines Möbels in Wirkverbindung steht,
**dadurch gekennzeichnet, dass**
die elektromotorische Antriebsanordnung (1) mindestens eine Messdatenverarbeitungsvorrichtung (4) zur Ermittlung zumindest eines zu dem Verschleiß der elektromotorischen Antriebsanordnung korrespondierenden Wertes aufweist, dass der Speicherbaustein (5) an der Messdatenverarbeitungsvorrichtung (4) angeordnet oder in ihr integriert ist und zur Speicherung des zumindest einen zu dem Verschleiß der elektromotorischen Antriebsanordnung (1) korrespondierenden Wertes vorgesehen ist und dass die Messdatenverarbeitungsvorrichtung (4) weiterhin eine Recheneinheit (6) zur Ausführung eines Rechenalgorithmus auf weist, wobei der Rechenalgorithmus zur Berechnung des zu dem Verschleiß der elektromotorischen Antriebsanordnung (1) korrespondierenden Wertes aus Betriebsparametern der elektromotorischen Antriebsanordnung (1) als Eingangsgrößen angepasst ist

2. Elektromotorische Antriebsanordnung (1) nach Anspruch 1, **dadurch gekennzeichnet, dass** die Messdatenverarbeitungsvorrichtung (4) weiterhin einen Zähler (7) zur Zählung von Einschaltvorgängen der elektromotorischen Antriebsanordnung (1) und/oder eine Zeitmesseinrichtung (8) zur Messung der Einschaltdauern der elektromotorischen Antriebsanordnung (1) aufweist, und die Betriebsparameter die gezählten Einschaltvorgänge und/oder gemessenen Einschaltdauern auf weisen.

3. Elektromotorische Antriebsanordnung (1) nach Anspruch 1 oder 2, **dadurch gekennzeichnet, dass** die Messdatenverarbeitungsvorrichtung (4) weiterhin eine Strommesseinrichtung (9) zur Messung von Stromwerten der elektromotorischen Antriebsanordnung (1) aufweist, wobei dieser Stromwert ein Betriebsparameter ist.

4. Elektromotorische Antriebsanordnung (1) nach einem der vorhergehenden Ansprüche, **dadurch gekennzeichnet, dass** die Messdatenverarbeitungsvorrichtung (4) einen digitalen Mikrocontroller (10) und/oder ein Netzwerk von verschalteten Operationsverstarkern in Form eines analogen Rechners mit zumindest einem Integrierer aufweist.

5. Elektromotorische Antriebsanordnung (1) nach einem der vorhergehenden Ansprüche, **dadurch gekennzeichnet, dass** die Messdatenverarbeitungsvorrichtung (4) eine Vergleichseinnchtung (11) zum Vergleich des in dem Speicherbaustein zu dem Verschleiß der elektromotorischen Antriebsanordnung (1) korrespondierenden gespeicherten Wertes mit einem vorgebbaren Sollwert aufweist.

6. Elektromotorische Antriebsanordnung (1) nach Anspruch 5, **dadurch gekennzeichnet, dass** die Messdatenverarbeitungsvorrrichtung (4) oder/und die Bedienungseinrichtung (3) eine Anzeigeeinrichtung (12) aufweist welche zur Anzeige eines aktuellen Verschleißzustandes in Abhängigkeit von einem durch die Vergleichseinrichtung (11) ermittelten Vergleichswertes ausgebildet ist.

7. Elektromotorische Antriebsanordnung (1) nach Anspruch 6, **dadurch gekennzeichnet, dass** die Anzeigeeinrichtung (12) in Form einer LCD- oder einer LED-Anzeige ausgebildet ist.

8. Elektromotorische Antriebsanordnung (1) nach Anspruch 7, **dadurch gekennzeichnet, dass** die Anzeigeeinrichtung (12) den aktuellen Verschleißzustand der elektromotorischen Antriebsanordnung (1) ein- oder mehrfarbig anzeigt.

9. Elektromotorische Antriebsanordnung (1) nach einem der Ansprüche 6 bis 8, **dadurch** dass die Anzeigeeinrichtung (12) eine Frist bis zur nächsten fälligen Wartung anzeigt.

10. Elektromotorische Antriebsanordnung (1) nach einem der vorhergehenden Ansprüche, **dadurch gekennzeichnet, dass** der Speicherbaustein (5) durch ein Auslesegerät auslesbar ist.

11. Elektromotorische Antriebsanordnung (1) nach einem der vorhergehenden Ansprüche, **dadurch gekennzeichnet, dass** der Speicherbaustein (5) zusätzlich zur Speicherung von zumindest einem Teil des Stromverlaufes und/oder der Einschaltdauer der elektromotorischen Antriebsanordnung (1) ausgebildet ist.

12. Verfahren zum Feststellen eines aktuellen Verschleißzustands einer elektromotorischen Antriebsanordnung (1) mit mindestens einem Elektromotor (2) und mit mindestens einer Bedienungseinrichtung (3) und einem Speicherbaustein (5), wobei die elektromotorische Antriebsanordnung (1) ein linear verfahrbares oder ein rotierend bewegliches Abtriebselement aufweist, welches mit einem zu verstellenden Bauteil eines Möbels in Wirkverbindung steht, **dadurch gekennzeichnet, dass**
Betriebsparameter der elektromotorischen Antriebsanordnung (1) erfasst und als Eingangsgrößen für ein Ermitteln eines Wertes durch eine Messdatenverarbeitungsvorrichtung (4) verwendet werden, und wobei ein Feststellen des Verschleißzustands der elektromotorischen Antriebsanordnung (1) anhand dieses ermittelten Wertes erfolgt, und dass der Speicherbaustein (5) an der Messdatenverarbeitungsvorrichtung (4) angeordnet oder in ihr integriert und zur Speicherung des zumindest einen zu dem Verschleiß der elektromotorischen Antriebsanordnung (1) korrespondierenden Wertes vorgesehen ist, dass die Messdatenverarbeitungsvorrichtung (4) weiterhin eine Recheneinheit (6) zur Ausführung eines Rechenalgorithmus aufweist, wobei der Rechenalgorithmus zur Berechnung des zu dem Verschleiß der elektromotorischen Antriebsanordnung (1) korrespondierenden Wertes aus Betriebsparametern der elektromotorischen Antriebsanordnung (1) als Eingangsgrößen angepasst ist.

13. Verfahren nach Anspruch 12, **dadurch gekennzeichnet, dass** ein Erfassen der Betriebsparameter ein Erfassen der Einschalthäufigkeit und ein Messen der Einschaltdauer der elektromotorische Antriebsanordnung (1) umfaßt.

14. Verfahren nach Anspruch 13, **dadurch gekennzeichnet, dass** ein Erfassen der Betriebsparameter weiterhin ein Messen zumindest eines Stromwertes der elektromotorischen Antriebsanordnung (1) aufweist.

15. Verfahren nach einem der Ansprüche 12 bis 14, **dadurch gekennzeichnet, dass** das Ermitteln des Wertes anhand von gespeicherten Tabellenwerten erfolgt.

16. Verfahren nach einem der Ansprüche 12 bis 14, **dadurch gekennzeichnet, dass** das Ermitteln des Wertes durch ein Berechnen mittels eines vorher festlegbaren Rechenalgorithmus erfolgt.

17. Verfahren nach einem der Ansprüche 12 bis 16, **dadurch gekennzeichnet, dass** das Feststellen des Verschleißzustands der elektromotorischen Antriebsanordnung (1) anhand des berechneten Wertes durch Vergleichen mit einem vorgebbaren Sollwert erfolgt.

18. Verfahren nach Anspruch 16, **dadurch gekennzeichnet, dass** der durch das Vergleichen erhaltene Verschleißzustand in dem Speicher (5) gespeichert wird und auf einer Anzeigeeinrichtung (12) anzeigbar und/oder mittels einer geeigneten Vorrichtung aus dem Speicher (5) auslesbar ist.

## Claims

1. Electric motor drive arrangement (1) having at least one electric motor (2) and having at least one control device (3) and a memory module (5), wherein the electric motor drive arrangement (1) has a linearly traversable or rotationally movable drive element which is actively connected to a component to be adjusted of an item of furniture, **characterized in that** the electric motor drive arrangement (1) has at least one measured data processing device (4) for determining at least one value corresponding to the wear of the electric motor drive arrangement, **in that** the memory module (5) is arranged at the measured data processing device (4) or is integrated therein and is intended for storing the at least one value corresponding to the wear of the electric motor drive arrangement (1), and **in that** the measured data processing device (4) furthermore has a calculating unit (6) for executing a calculation algorithm, wherein the calculation algorithm is adapted to calculate the value corresponding to the wear of the electric motor drive arrangement (1) from operating parameters of the electric motor drive arrangement (1) as input variables.

2. Electric motor drive arrangement (1) according to Claim 1, **characterized in that** the measured data processing device (4) furthermore has a counter (7) for counting switch-on operations of the electric motor drive arrangement (1) and/or a timer (8) for measuring the switch-on time of the electric motor drive arrangement (1), and the operating parameters include the counted switch-on operations and/or measured switch-on times.

3. Electric motor drive arrangement (1) according to Claim 1 or 2, **characterized in that** the measured data processing device (4) furthermore has a current measuring device (9) for measuring current values of the electric motor drive arrangement (1), wherein this current value is an operating parameter.

4. Electric motor drive arrangement (1) according to one of the preceding claims, **characterized in that** the measured data processing device (4) has a digital microcontroller (10) and/or a network of connected operational amplifiers in the form of an analogue computer with at least one integrator.

5. Electric motor drive arrangement (1) according to one of the preceding claims, **characterized in that** the measured data processing device (4) has a comparator device (11) for comparing the value corresponding to the wear of the electric motor drive arrangement (1) stored in the memory module with a specifiable setpoint.

6. Electric motor drive arrangement (1) according to Claim 5, **characterized in that** the measured data processing device (4) or/and the control device (3) has a display device (12) which is designed to display a current state of wear as a function of a comparison value determined by the comparator device (11).

7. Electric motor drive arrangement (1) according to Claim 6, **characterized in that** the display device (12) is designed in the form of an LCD or an LED display.

8. Electric motor drive arrangement (1) according to Claim 7, **characterized in that** the display device (12) displays the current state of wear of the electric motor drive arrangement (1) in one or more colours.

9. Electric motor drive arrangement (1) according to one of Claims 6 to 8, **characterized in that** the display device (12) displays a time until the next scheduled service.

10. Electric motor drive arrangement (1) according to one of the preceding claims, **characterized in that** the memory module (5) can be read out by means of a reader.

11. Electric motor drive arrangement (1) according to one of the preceding claims, **characterized in that** the memory module (5) is additionally designed for storing at least part of the current characteristic and/or the switch-on time of the electric motor drive arrangement (1).

12. Method for establishing a current state of wear of an electric motor drive arrangement (1) having at least one electric motor (2) and having at least one control device (3) and a memory module (5), wherein the electric motor drive arrangement (1) has a linearly traversable or rotationally movable drive element which is actively connected to a component to be adjusted of an item of furniture, **characterized in that** operating parameters of the electric motor drive arrangement (1) are measured and used as input variables for determining a value by a measured data processing device (4), and wherein the state of wear of the electric motor drive arrangement (1) is established based on this determined value, and **in that** the memory module (5) is arranged at the measured data processing device (4) or is integrated therein and is intended for storing the at least one value corresponding to the wear of the electric motor drive arrangement (1), and **in that** the measured data processing device (4) furthermore has a calculating unit (6) for executing a calculation algorithm, wherein the calculation algorithm is adapted to calculate the value corresponding to the wear of the electric motor drive arrangement (1) from operating parameters of the electric motor drive arrangement (1) as input variables.

13. Method according to Claim 12, **characterized in that** a measurement of the operating parameters includes a measurement of the switch-on frequency and a measurement of the switch-on time of the electric motor drive arrangement (1).

14. Method according to Claim 13, **characterized in that** a measurement of the operating parameters furthermore includes a measurement of at least one current value of the electric motor drive arrangement (1).

15. Method according to one of claims 12 to 14, **characterized in that** the value is determined based on stored table values.

16. Method according to one of claims 12 to 14, **characterized in that** the value is determined by a calculation by means of a previously definable calculation algorithm.

17. Method according to one of claims 12 to 16, **characterized in that** the state of wear of the electric motor drive arrangement (1) is established based on the calculated value by comparison with a specifiable setpoint.

18. Method according to Claim 16, **characterized in that** the state of wear obtained by the comparison is stored in the memory (5) and can be displayed on a display device (12) and/or can be read out of the memory (5) by means of a suitable device.

## Revendications

1. Dispositif d'entraînement par moteur électrique (1) ayant au moins un moteur électrique (2) et au moins un système de commande (3) et un composant mémoire (5), le dispositif d'entraînement par moteur électrique (1) comportant un élément d'entraînement à déplacement linéaire ou à déplacement rotatif qui est en liaison opérative avec une partie d'un meuble à déplacer,
**caractérisé en ce que**
le dispositif d'entraînement par moteur électrique (1) comporte au moins un dispositif de traitement de données de mesure (4) destiné à déterminer au moins une valeur correspondant à l'usure du dispositif d'entraînement par moteur électrique, **en ce que** le composant mémoire (5) est disposé sur le dispositif de traitement de données de mesure (4) ou est intégré dans ce dernier et est prévu pour stocker la ou les valeurs correspondant à l'usure du dispositif d'entraînement par moteur électrique (1) et **en ce que** le dispositif de traitement de données de mesure (4) comporte en outre une unité de calcul (6) permettant d'exécuter un algorithme de calcul, l'algorithme de calcul étant adapté pour calculer la valeur correspondant à l'usure du dispositif d'entraînement par moteur électrique (1) à partir de paramètres de fonctionnement du dispositif d'entraînement par moteur électrique (1) en tant que grandeurs d'entrée.

2. Dispositif d'entraînement par moteur électrique (1) selon la revendication 1, **caractérisé en ce que** le dispositif de traitement de données de mesure (4) comporte en outre un compteur (7) permettant de compter des opérations de mise en marche du dispositif d'entraînement par moteur électrique (1) et/ou un système de mesure de temps (8) permettant de mesurer des durées de fonctionnement du dispositif d'entraînement par moteur électrique (1), et **en ce que** les paramètres de fonctionnement comportent les opérations de mise en marche comptées et/ou les durées de fonctionnement mesurées.

3. Dispositif d'entraînement par moteur électrique (1) selon la revendication 1 ou 2, **caractérisé en ce que** le dispositif de traitement de données de mesure (4) comporte en outre un système de mesure de courant (9) permettant de mesurer des valeurs de courant du dispositif d'entraînement par moteur électrique (1), cette valeur de courant étant un paramètre de fonctionnement.

4. Dispositif d'entraînement par moteur électrique (1) selon l'une quelconque des revendications précédentes, **caractérisé en ce que** le dispositif de traitement de données de mesure (4) comporte un microcontrôleur numérique (10) et/ou un réseau d'amplificateurs opérationnels reliées ensemble sous la forme d'un calculateur analogique pourvu d'au moins un intégrateur.

5. Dispositif d'entraînement par moteur électrique (1) selon l'une quelconque des revendications précédentes, **caractérisé en ce que** le dispositif de traitement de données de mesure (4) comporte un système de comparaison (11) permettant de comparer la valeur, stockée dans le composant mémoire et correspondant à l'usure du dispositif d'entraînement par moteur électrique (1), à une valeur de consigne pouvant être prédéfinie.

6. Dispositif d'entraînement par moteur électrique (1) selon la revendication 5, **caractérisé en ce que** le dispositif de traitement de données de mesure (4) ou/et le système de commande (3) comporte un système d'affichage (12) qui est formé pour afficher un état d'usure actuel en fonction d'une valeur de comparaison déterminée par le système de comparaison (11).

7. Dispositif d'entraînement par moteur électrique (1) selon la revendication 6, **caractérisé en ce que** le système d'affichage (12) est conçu sous forme d'un affichage à cristaux liquides (LCD) ou à diodes électroluminescentes (DEL).

8. Dispositif d'entraînement par moteur électrique (1) selon la revendication 7, **caractérisé en ce que** le système d'affichage (12) affiche l'état d'usure actuel du dispositif d'entraînement par moteur électrique (1) avec une ou plusieurs couleurs.

9. Dispositif d'entraînement par moteur électrique (1) selon l'une des revendications 6 à 8, **caractérisé en ce que** le système d'affichage (12) affiche une échéance jusqu'à la prochaine maintenance prévue.

10. Dispositif d'entraînement par moteur électrique (1) selon l'une quelconque des revendications précédentes, **caractérisé en ce que** le composant mémoire (5) peut être lu par un appareil de lecture.

11. Dispositif d'entraînement par moteur électrique (1) selon l'une quelconque des revendications précédentes, **caractérisé en ce que** le composant mémoire (5) est conçu en plus pour stocker au moins une partie de la courbe de courant et/ou de la durée de fonctionnement du dispositif d'entraînement par moteur électrique (1).

12. Procédé pour déterminer un état d'usure actuel d'un dispositif d'entraînement par moteur électrique (1) ayant au moins un moteur électrique (2) et au moins un système de commande (3) et un composant mémoire (5), le dispositif d'entraînement par moteur électrique (1) comportant un élément d'entraînement à déplacement linéaire ou à déplacement rotatif qui est en liaison opérative avec une partie d'un meuble à déplacer,
**caractérisé en ce que**
des paramètres de fonctionnement du dispositif d'entraînement par moteur électrique (1) sont détectés et sont employés en tant que grandeurs d'entrée pour déterminer une valeur par un dispositif de traitement de données de mesure (4), et une détermination de l'état d'usure du dispositif d'entraînement par moteur électrique (1) étant effectuée à l'aide de cette valeur déterminée, et **en ce que** le composant mémoire (5) est disposé sur le dispositif de traitement de données de mesure (4) ou est intégré dans ce dernier et est prévu pour stocker la ou les valeurs correspondant à l'usure du dispositif d'entraînement par moteur électrique (1), **en ce que** le dispositif de traitement de données de mesure (4) comporte en outre une unité de calcul (6) permettant d'exécuter un algorithme de calcul, l'algorithme de calcul étant adapté pour calculer la valeur correspondant à l'usure du dispositif d'entraînement par moteur électrique (1) à partir de paramètres de fonctionnement du dispositif d'entraînement par moteur électrique (1) en tant que grandeurs d'entrée.

13. Procédé selon la revendication 12, **caractérisé en ce qu'**une détection des paramètres de fonctionnement comporte une détection de la fréquence de mise en marche et une mesure des durées de fonctionnement du dispositif d'entraînement par moteur électrique (1).

14. Procédé selon la revendication 13, **caractérisé en ce qu'**une détection des paramètres de fonctionnement comporte en outre une mesure d'au moins une valeur de courant du dispositif d'entraînement par moteur électrique (1).

15. Procédé selon l'une quelconque des revendications 12 à 14, **caractérisé en ce que** la détermination de la valeur est effectuée à l'aide de valeurs de tableau enregistrées.

16. Procédé selon l'une quelconque des revendications 12 à 14, **caractérisé en ce que** la détermination de la valeur est effectuée par un calcul au moyen d'un algorithme de calcul pouvant être défini au préalable.

17. Procédé selon l'une quelconque des revendications 12 à 16, **caractérisé en ce que** la détermination de l'état d'usure du dispositif d'entraînement par moteur électrique (1) est effectuée à l'aide de la valeur calculée par comparaison à une valeur de consigne pouvant être prédéfinie.

18. Procédé selon la revendication 16, **caractérisé en ce que** l'état d'usure obtenu par la comparaison est stocké dans la mémoire (5) et peut être affiché sur un système d'affichage (12) et/ou être lu dans la mémoire (5) au moyen d'un système approprié.
